(19)

Europäisches Patentamt
European Patent Office
Office européen des brevets

(11) **EP 2 105 920 A1**

(12) **EUROPEAN PATENT APPLICATION**

(43) Date of publication:
**30.09.2009 Bulletin 2009/40**

(51) Int Cl.:
***G11B 5/855*** (2006.01)      ***B29C 33/38*** (2006.01)
***B29C 33/42*** (2006.01)

(21) Application number: **09004171.6**

(22) Date of filing: **24.03.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **25.03.2008 JP 2008078757**
**17.12.2008 JP 2008321436**

(71) Applicant: **Fujifilm Corporation**
**Tokyo 106-8620 (JP)**

(72) Inventor: **Nishikawa, Masakazu**
**Odawara-shi**
**Kanagawa (JP)**

(74) Representative: **HOFFMANN EITLE**
**Patent- und Rechtsanwälte**
**Arabellastrasse 4**
**81925 München (DE)**

(54) **Imprint mold structure and imprint method using the same, and method for manufacturing magnetic recording medium**

(57)    Provided is an imprint mold structure containing: a substrate; and a concave-convex portion formed by arranging on one surface of the substrate convex portions with reference to the surface, the imprint mold structure being used for an imprint method containing a transferring step and a curing step, wherein the imprint mold structure satisfies the following formula 1:

$$HBR < HMS < HAR \qquad \text{Formula 1}$$

where HMS is a hardness of an outermost surface on the transfer side of the imprint mold structure, HBR is a hardness of the imprint resist layer in the transferring, HAR is a hardness of the imprint resist layer after the curing, and HMS is 1 GPa or less.

FIG. 1

**Description**

BACKGROUND OF THE INVENTION

Field of the Invention

The present invention relates to an imprint mold structure and an imprint method using the imprint mold structure, and a method for manufacturing a magnetic recording medium.

Description of the Related Art

In recent years, hard disk drives having excellent high speed and cost performance have begun to be mounted on portable equipment, such as cellular phones, small audio equipment, and video cameras, as dominant storage equipment.

Then, with the increase of their share as recording devices mounted on portable equipment, demand for further smaller size and larger capacity should be met, and techniques for improving the recording density are required.

In order to increase the recording density of the hard disk drive, the methods of decreasing the data track interval in the magnetic recording medium, and decreasing the width of the magnetic head have been conventionally used.

However, by decreasing the data track interval, the magnetic effect between adjacent tracks (crosstalk), and the effect of thermal fluctuations become significant, which limit the recording density.

On the other hand, the improvement of the surface recording density by decreasing the width of the magnetic head is also limited.

Then, as means for solving noise due to the crosstalk, magnetic recording media called discrete track media are proposed. In the discrete track media, the magnetic interference between adjacent tracks is reduced by providing a discrete structure in which a nonmagnetic guard band region is provided between adjacent tracks to magnetically separate individual tracks.

Also, as means for solving demagnetization due to the thermal fluctuations, magnetic recording media previously provided with individual bits for signal recording in a predetermined shape pattern, called patterned media, are proposed.

When the above discrete track media and patterned media are manufactured, an imprinting method (imprint process) is used, in which the desired pattern is transferred to a resist layer formed on a surface of a magnetic recording medium, using a resist pattern forming mold (hereinafter sometimes referred to as a "mold") (see Japanese Patent Application Laid-Open (JP-A) No. 2004-221465).

In the imprint process, a resist is applied to an object to be subjected to shape processing, the mold is brought into close contact with and pressed to the object to form a resist pattern. So far, the improvement of the durability of the mold has been studied and a hard protective layer (for example, a DLC film) is formed on the surface layer of the mold (see Japanese Patent Application Laid-Open (JP-A) No. 2002-203342). However, in this method, if nanometer-size contaminations (particles) are present between the mold and the object to be processed, pressure is applied directly and locally to the object, so that the object itself may be broken.

The present inventor has reached, and implemented, the idea that by decreasing the hardness of the resist before the transferring step below the hardness of the mold, the pressing of the pattern against the resist would become easy independently of the cross-sectional area of the pattern and the depth, and the moldability of the pattern would be improved. As a result, the moldability of the pattern has been significantly improved. In addition, the particles present between the mold and the resist were embedded in the resist without damaging the mold, and the failure of the mold due to the particles can be significantly improved.

Thus, the moldability of the pattern, and the degradation of the durability of the mold due to the particles were improved, but as a result of analyzing in detail the shape of the resist pattern after transferring, it was confirmed that minute burrs occurred in the cross section of the pattern. When the reproduced signals from magnetic recording media fabricated with this resist pattern (resist mask) were checked, there were cases where due to the effect of the mask burrs, the signal symmetry was degraded, address detection errors occurred in the servo region, and the magnetic recording medium did not function as a drive.

BRIEF SUMMARY OF THE INVENTION

It is an object of the present invention to provide an imprint mold structure having high releasability, an imprint method that reduces the breakage of the pattern transferred to a resist in releasing the mold from the resist after the transferring step, and a method for manufacturing a magnetic recording medium having improved signal quality.

As means for solving the above problems, the following is provided:

<1> An imprint mold structure containing: a substrate; and a concave-convex portion formed by arranging on one surface of the substrate a plurality of convex portions with reference to the surface, in which the imprint mold structure being used for an imprint method containing at least: pressing the concave-convex portion of the imprint mold structure as a transfer surface against an imprint resist layer formed of an imprint resist composition on a laminate containing a substrate for a magnetic recording medium and at least a magnetic layer laminated on the substrate so as to transfer a concave-convex pattern based on the concave-convex portion; and curing the imprint resist layer to which the concave-convex pattern is transferred, wherein the imprint mold structure satisfies the following formula 1:

$$HBR < HMS < HAR \qquad \text{Formula 1}$$

in which HMS is a hardness of an outermost surface on the transfer side of the imprint mold structure, HBR is a hardness of the imprint resist layer in the transferring, HAR is a hardness of the imprint resist layer after the curing, and HMS is 1 GPa or less.

<2> The imprint mold structure according to <1>, wherein the imprint mold structure further contains at least one release layer on the surface on the transfer side of the imprint mold structure.

<3> The imprint mold structure according to any of <1> or <2>, wherein the outermost surface on the transfer side of the imprint mold structure is a release layer.

<4> The imprint mold structure according to any of <2> or <3>, wherein a material of the release layer is a fluorocarbon (CF)-based material.

<5> The imprint mold structure according to any one of <1> to <4>; wherein the imprint mold structure satisfies the following formula 2:

$$HMS < HMB \qquad \text{Formula 2}$$

in which HMB is a hardness of the substrate of the imprint mold structure, and HMB is 5 GPa or more.

<6> An imprint method containing:

pressing a concave-convex portion of the imprint mold structure as a transfer surface against an imprint resist layer formed of an imprint resist composition on a laminate containing a substrate for a magnetic recording medium and at least a magnetic layer laminated on the substrate so as to transfer a concave-convex pattern based on the concave-convex portion; and curing the imprint resist layer to which the concave-convex pattern is transferred, wherein the imprint mold structure contains: a substrate; and the concave-convex portion formed by arranging on one surface of the substrate a plurality of convex portions with reference to the surface, and wherein the imprint mold structure satisfies the following formula 1:

$$HBR < HMS < HAR \qquad \text{Formula 1}$$

in which HMS is a hardness of an outermost surface on the transfer side of the imprint mold structure, HBR is a hardness of the imprint resist layer in the transferring, HAR is a hardness of the imprint resist layer after the curing, and HMS is 1 GPa or less.

<7> The imprint method according to <6>, wherein the imprint mold structure further contains a release layer on the outermost surface on the transfer side of the imprint mold structure, and wherein the imprint mold structure satisfies the following formula 2:

$$HMS < HMB \qquad \text{Formula 2}$$

in which HMS is a hardness of the release layer, HMB is a hardness of the substrate of the imprint mold structure, and HMB is 5 GPa or more.

<8> The imprint method according to <7>, wherein a material of the release layer is a fluorocarbon (CF)-based material.

<9> A method for manufacturing a magnetic recording medium, containing:

pressing an imprint mold structure against an imprint resist layer formed of an imprint resist composition on a laminate containing a substrate for a magnetic recording medium and at least a magnetic layer laminated on the substrate so as to transfer a concave-convex pattern based on a concave-convex portion of the imprint mold structure, the imprint mold structure containing a substrate, and the concave-convex portion formed by arranging on one surface of the substrate a plurality of convex portions with reference to the surface;

curing the imprint resist layer to which the concave-convex pattern is transferred; etching the magnetic layer, using as a mask the imprint resist layer, to which the concave-convex pattern is transferred and which is cured, to form a magnetic pattern portion, based on the concave-convex pattern, in the magnetic layer; and filling a concave portion dividing the magnetic layer with a nonmagnetic material to form a nonmagnetic pattern portion, wherein the imprint mold structure satisfies the following formula 1:

$$HBR < HMS < HAR \qquad \text{Formula 1}$$

in which HMS is a hardness of a transfer surface of the imprint mold structure, HBR is a hardness of the imprint resist layer in the transferring, HAR is a hardness of the imprint resist layer after the curing, and HMS is 1 GPa or less.

<10> The method for manufacturing a magnetic recording medium according to <9>, wherein the imprint mold structure further contains a release layer on the outermost surface on the transfer side of the imprint mold structure, and wherein the imprint mold structure satisfies the following formula 2:

$$HMS < HMB \qquad \text{Formula 2}$$

in which HMS is a hardness of the release layer, HMB is a hardness of the substrate of the imprint mold structure, and HMB is 5 GPa or more.

<11> The method for manufacturing a magnetic recording medium according to <10>, wherein a material of the release layer is a fluorocarbon-based material.

<12> A magnetic recording medium manufactured according to the method for manufacturing a magnetic recording medium as in any one of <9> to <11>.

The present invention can provide an imprint mold structure having high releasability, an imprint method that reduces the breakage of the pattern transferred to a resist in releasing the mold from the resist after the transferring step, and a method for manufacturing a magnetic recording medium having improved signal quality.

BRIEF DESCRIPTION OF THE DRAWINGS

FIG. 1 is a perspective view showing the configuration of the imprint mold structure of the present invention;

FIG. 2 is a cross-sectional view showing the configuration of the imprint mold structure of the present invention in one embodiment;

FIG. 3A is a cross-sectional view showing a method for manufacturing the imprint mold structure of the present invention;

FIG. 3B is a cross-sectional view showing the method for manufacturing the imprint mold structure of the present invention;

FIG. 4 is a cross-sectional view showing one embodiment of a method for manufacturing a magnetic recording medium using the imprint mold structure of the present invention; and

FIG. 5 is a perspective view showing the configuration of the magnetic recording medium of the present invention.

DETAILED DESCRIPTION OF THE INVENTION

The imprint mold structure of the present invention will be described below with reference to the drawings.

(Imprint Mold Structure)

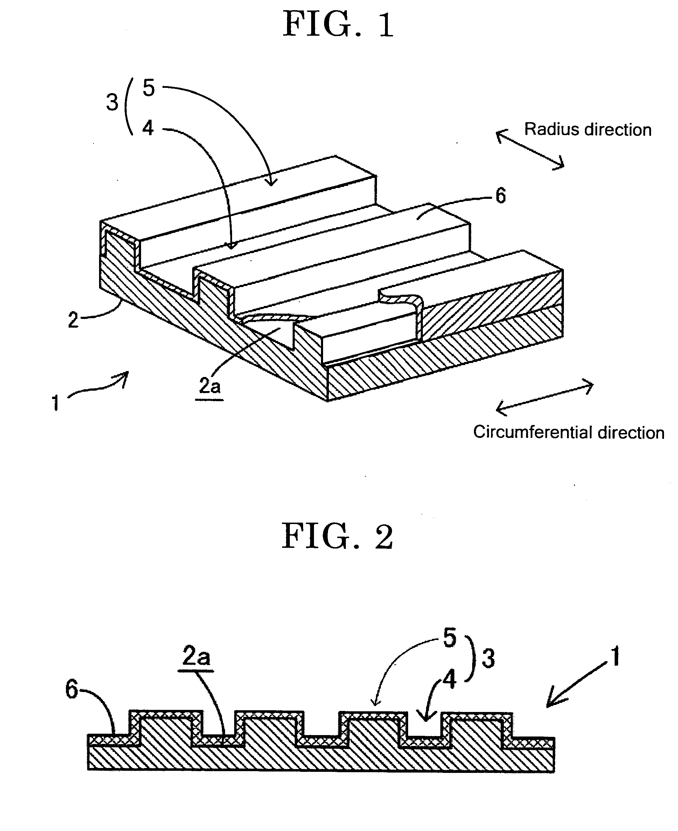

FIG. 1 is a perspective view showing the schematic configuration of the imprint mold structure of the present invention. FIG. 2 is cross sectional view of the imprint mold structure shown in FIG. 1.

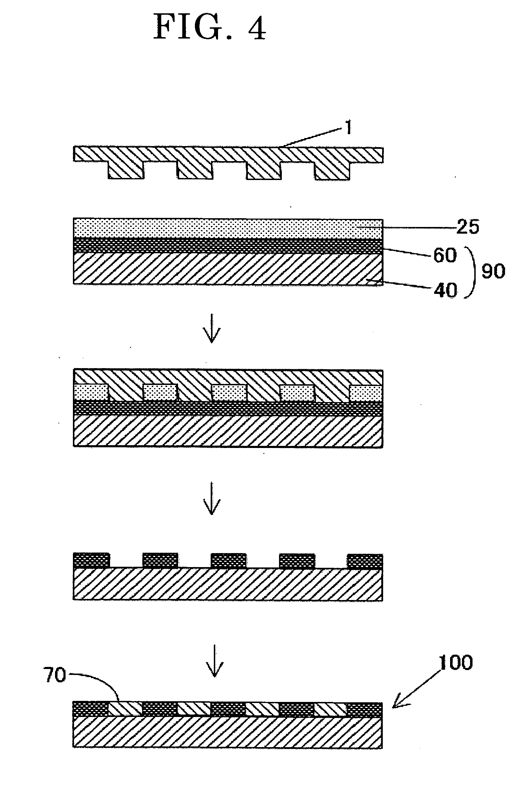

As shown in FIG. 1, an imprint mold structure 1 is configured to press an object to be processed (for example, an imprint resist 25 in FIG. 4 described later), and has at least a disk-shaped substrate 2, and a concave-convex portion 3 formed by arranging on one surface 2a of the substrate 2 a plurality of convex portions 5 at predetermined intervals with reference to the surface 2a, with a concave portion 4 formed between the convex portions 5. The imprint mold structure 1 further includes other members as required. In FIGs. 1 and 2, the reference numeral 6 represents a release layer formed on a surface of the concave-convex portions.

Here, the concave-convex portion 3 formed in the imprint mold structure 1 has at least a data region concave-convex portion 3 formed by concentrically arranging a plurality of convex portions at predetermined intervals with reference to the surface 2a, and a servo region concave-convex portion 3 formed by radially arranging on the surface 2a a plurality of convex portions at predetermined intervals in the radial direction with reference to the surface 2a. The concave-convex portion 3 further includes other members as required.

Also, the cross-sectional shape of the concave-convex portion 3 in a plane including the radial direction of the substrate 2 is not particularly limited and is appropriately selected according to the purpose. For example, a generally rectangular shape is preferred.

For the cross-sectional shape of the concave-convex portion 3, any shape can be selected by controlling an etching step described later.

Here, a plurality of the servo regions are formed at generally equal intervals in the circumferential direction so as to divide the data region.

Also, the servo region is divided into a preamble portion, an address portion, and a burst portion.

The preamble portion is a region in which information for synchronizing a reproduction signal clock is recorded. Specifically, the preamble portion is provided to perform PLL processing for synchronizing a servo signal reproduction clock with respect to time difference caused by the rotational eccentricity of a magnetic recording medium, AGC processing for properly maintaining the amplitude of a reproduced signal, and the like.

The address portion.is a region in which a servo signal recognition code called a servo mark, sector information, cylinder information, and the like are formed by Manchester code at the same pitch as the pitch of the preamble portion in the circumferential direction.

The cylinder information has a pattern in which the information changes for each servo track. Therefore, the cylinder information is converted to a code in which a change in adjacent tracks is minimum, called gray code, then Manchester coded, and recorded, so that the effect of an address reading error during a head seek operation is reduced.

The burst portion is an off-track detection region for detecting the off-track amount with respect to the on-track state of a cylinder address, and in the burst portion, four marks having pattern phases shifted in the radial direction, called A, B, C, and D bursts, are further formed.

In each burst, a plurality of marks are located at the same pitch period as that in the preamble portion, in the circumferential direction, and the radial period is proportional to a period at which the address pattern changes, in other words, a servo track period. In this embodiment, each burst is formed for 10 periods in the circumferential direction and is repeated in the radial direction at a period twice as long as the servo track period.

In the imprint mold structure 1, the hardness of the transfer surface (the surface on which the concave-convex pattern is formed) is preferably selected to satisfy the following formula 1:

$$HBR < HMS < HAR \qquad \text{Formula 1}$$

in which HBR is the hardness of the imprint resist layer in the transferring step, HAR is the hardness of the imprint resist layer after the curing step, and HMS is 1GPa or less (i.e., $HMS \leq 1$ GPa).

Also, one or more release layers are preferably formed on the transfer surface side of the imprint mold structure 1, and more preferably, the outermost surface layer thereof is a release layer.

[Release Layer]

The hardness HMS of a release layer 6 satisfies the following formula 1:

$$HBR < HMS < HAR \qquad \text{Formula 1}$$

in which HBR is the hardness of the imprint resist layer in the transferring step, HAR is the hardness of the imprint resist layer after the curing step, and HMS is 1 GPa or less (i.e., HMS $\leq$ 1 GPa).

Also, the hardness HMS of the release layer 6 constituting the outermost surface on the transfer side of the imprint mold structure further preferably satisfies the following formula 2:

$$HMS < HMB \qquad \text{Formula 2}$$

in which HMB is the hardness of the substrate 2 of the imprint mold structure 1, and HMB is 5 GPa or more (i.e., HMB $\geq$ 5 GPa).

Also, the material of the release layer 6 is not particularly limited as long as it is a material having a release function for the object to be processed (resist), and it can be appropriately selected according to the purpose. The material of the release layer 6 includes, for example, fluorocarbon (CF)-based materials, publicly known fluorine-based resins, hydrocarbon-based lubricants, fluorine-based lubricants, and fluorine-based silane coupling agents. Among these, fluorocarbon (CF)-based materials are particularly preferred in that the adsorption properties to the substrate, and the coverage of the substrate surface can be increased, and the like.

The fluorocarbon (CF)-based materials include, for example, as those having perfluoropolyether groups, perfluoromethylene oxide polymers, perfluoroethylene oxide polymers, perfluoro-n-propylene oxide polymers $(CF_2CF_2CF_2O)n$, and perfluoroisopropylene oxide polymers $(CF(CF_3)CF_2O)n$, and copolymers thereof.

The fluorine-based resins include, for example, PTFA, PFA, FEP, and ETFE.

The hydrocarbon-based lubricants include, for example, carboxylic acids, such as stearic acid and oleic acid, esters, such as butyl stearate, sulfonic acids, such as octadecylsulfonic acid, phosphoric acid esters, such as monooctadecyl phosphate, alcohols, such as stearyl alcohol and oleyl alcohol, carboxylic acid amides, such as stearic acid amide, and amines, such as stearylamine.

The fluorine-based lubricants include a lubricant in which part or all of the alkyl groups of the above hydrocarbon-based lubricant are substituted with fluoroalkyl groups or perfluoropolyether groups. The perfluoropolyether groups are perfluoromethylene oxide polymers, perfluoroethylene oxide polymers, perfluoro-n-propylene oxide polymers $(CF_2CF_2CF_2O)n$, or perfluoroisopropylene oxide polymers $(CF(CF_3)CF_2O)n$, or copolymers thereof, or the like.

As the fluorine-based silane coupling agents, those having at least 1, preferably 1 to 10 alkoxysilane groups or chlorosilane groups in the molecule and having a molecular weight of 200 to 500,000 are preferred. Examples of the alkoxysilane groups include a $-Si(OCH_3)_3$ group, a $-Si(OCH_2CH_3)_3$ group, and a $.Si(OCH_3)_3$ group. The chlorosilane groups include a $-Si(Cl)_3$ group and the like. Specifically, the fluorine-based silane coupling agents are materials, such as, heptadecafluoro-1,1,2,2-tetra-hydrodecyltrimethoxysilane, pentafluorophenylpropyldimethylchlorosilane, tridecafluoro-1,1,2,2-tetra-hydrooctyltriethoxysilane, and tridecafluoro-1,1,2,2-tetra-hydrooctyltrimethoxysilane.

As commercially available materials having a release function, Z-TETRAOL and Z-DOL (manufactured by Solvay Solexis) are particularly preferred.

<Hardness Measurement Method>

Here, the hardness can be measured using a measurement apparatus, such as a nanoindenter. The nanoindenter is a nanoindentation hardness tester used for a nanoindentation hardness test (nanoindentation test) in which the relationship between the microload and the microdisplacement when a sample is indented to tens of nm to tens of $\mu$m by a triangular pyramid indenter having a tip radius of about 0.1 $\mu$m to about 1 $\mu$m, and the relationship between the microload and the microdisplacement when the indenter is returned and the load is removed are measured, and from the obtained load-displacement curve, the hardness and elastic modulus at depth in the nanometer region are obtained.

For a specific measurement method, indentation is performed at an indentation load of 5 $\mu$N, at an indentation speed of 3 nm/second, using a triangular pyramid type having a diamond tip having a dihedral angle of 90 degrees and a curvature radius of 40 nm, and using TRIBOSCOPE (manufactured by HYSITRON), a pressure of up to 5 $\mu$N is applied, and subsequently, the pressure is gradually returned. The maximum load at this time, 5 $\mu$N, is divided by the projected area of the indenter contact portion to obtain the hardness. [Other Members]

The other members are not particularly limited unless the effect of the present invention is impaired. The other members can be appropriately selected according to the purpose and include, for example, a mold layer provided between the mold substrate 4 and the release layer 6.

<<Imprint Resist Layer>>

The imprint resist layer 25 is a layer formed by applying an imprint resist composition (hereinafter sometimes referred to as an "imprint resist solution" to the substrate of a magnetic recording medium.

The imprint resist composition is not particularly limited and can be appropriately selected from publicly known ones according to the purpose. The imprint resist composition includes, for example, thermoplastic resins, and photocurable resins, such as ultraviolet curing resins. Novolak-based resins, acrylic resins, epoxy resins, organic glass resins, and inorganic glass resins are preferred; and acrylic resins and ultraviolet curing resins are particularly preferred.

The thickness of the imprint resist layer is preferably 5% or more and less than 200% of the height of the convex portions formed on the surface 2a of the mold 1. Below 5%, the amount of the resist is insufficient, so that the desired resist pattern cannot be formed.

For the thickness of the imprint resist layer, for example, part of the resist is released from the resist-applied substrate, and a difference in level after the release can be measured by an AFM apparatus (Dimension 5000, manufactured by Veeco Japan).

[Viscosity of Imprint Resist Composition]

The viscosity of the imprint resist composition is measured using, for example, an ultrasonic viscometer or the like.

The viscosity P of the imprint resist composition thus measured is preferably 0.5 mPa·s to 70 mPa·s.

<Methods for Fabricating Imprint Mold Structure>

Examples of a method for fabricating the imprint mold structure of the present invention will be described below with reference to the drawings. The imprint mold structure used in the present invention may be fabricated by a fabricating method other than the following fabricating methods.

- Fabrication of Master -

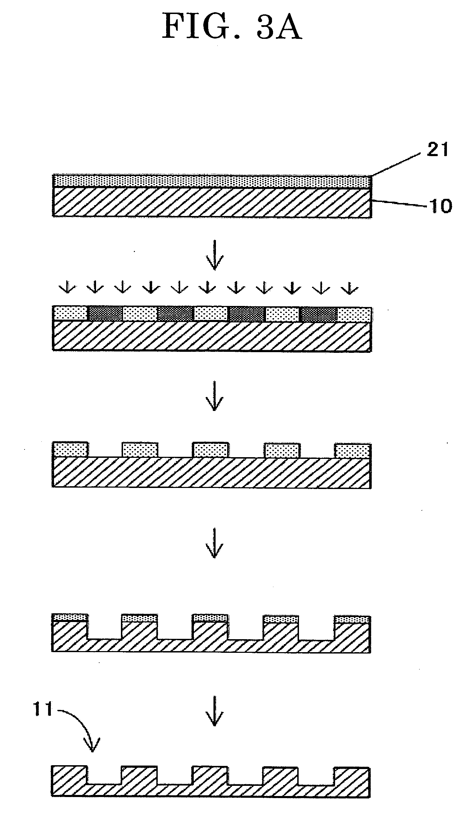

FIGS. 3A to 3B are cross-sectional views showing a method for fabricating the mold structure 1. As shown in FIG. 3A, first, a photoresist solution, such as a novolak-based resin and an acrylic resin, is applied onto a Si substrate 10 by spin coating or the like to form a photoresist layer 21.

Subsequently, the Si substrate 10 is exposed with laser light (or an electron beam) modulated corresponding to a servo signal, while being rotated, to expose a predetermined pattern on the entire surface of the photoresist, for example, a pattern corresponding to the servo signal, linearly extending in the radial direction from the center of rotation to tracks, on portions corresponding to circumferential frames.

Subsequently, the photoresist layer 21 is subjected to development treatment, the exposed portions are removed, and selective etching is performed by RIE or the like, using as a mask the pattern of the photoresist layer 21 after the removal, to obtain a master 11 having a concave-convex shape.

As a mold fabricating method for fabricating a mold from the master 11, a plating method, a nanoimprint method, and the like can be used.

The mold fabricating method using a plating method is as follows.

First, a conductive layer (not shown) is formed on the surface of the master 11.

As the method for forming the conductive film, generally, a vacuum film forming method (sputtering, vapor deposition, and the like), an electroless plating method, and the like can be used.

As the material of the conductive layer, metals and alloys containing at least one element of Ni, Cr, W, Ta, Fe, and Co can be used, and Ni, Co, FeCo alloy, and the like are preferred. Also, nonmetal materials exhibiting conductivity, such as TiO, can be used for the conductive layer.

The film thickness of the conductive layer is preferably in the range of 5 nm to 30 nm, and more preferably in the range of 10 nm to 25 nm.

Using the master on which the above conductive layer is formed, a metal and an alloy material are laminated by a plating method to a predetermined thickness, and then, the plated substrate is released from the master 11 to form a mold.

Here, as the plating material constituting the mold, Ni, Cr, FeCo alloy, and the like can be used, and those using Ni materials are particularly preferred.

Also, the thickness of the mold 1 after the release is preferably in the range of 30 $\mu$m to 500 $\mu$m, and more preferably in the range of 45 $\mu$m to 300 $\mu$m. Below 30 $\mu$m, the rigidity of the mold decreases, so that the mechanical properties cannot be ensured.

In addition, by performing the above transferring step (NIL, nanoimprint lithography) many times, the mold 1 itself is deformed, so that the practical properties may decreases significantly. Therefore, if the thickness of the mold is 500 $\mu$m or more, the rigidity is too high, so that the close contact between the mold 1 and the substrate 40 of a magnetic recording medium during NIL cannot be ensured.

In order to ensure the close contact, the close contact pressure should be increased, so that when foreign substances and the like are present, fatal shape defects occur between the mold 1 and the substrate 40 of the magnetic recording medium.

Using the above mold as the master 11, the mold 1 may be replicated.

The mold replicating method using a nanoimprint method is as follows.

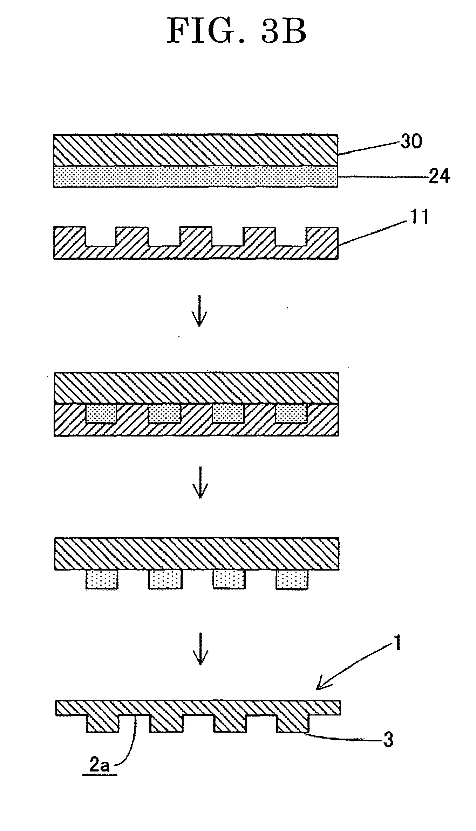

As shown in FIG. 3B, the master 11 is pressed against a substrate 30, on one surface of which an imprint resist layer 24 is formed by applying an imprint resist solution containing a thermoplastic resin or a photocurable resin, so that the pattern of convex portions formed on the master 11 is transferred to the imprint resist layer 24.

Here, the material of the substrate 30 is not particularly limited as long as it is a material having light transmissiveness and having strength for functioning as the mold structure 1, and it is appropriately selected according to the purpose. For example, quartz ($SiO_2$), organic resins (PET, PEN, polycarbonate, low melting point fluororesin), and the like are preferred, and quartz ($SiO_2$) is particularly preferred.

Also, the "having light transmissiveness" specifically means that when light is allowed to enter from the other surface of the substrate 30 so as to exit from one surface of the substrate 30 on which the imprint resist layer 24 is formed, the imprint resist solution is sufficiently cured. The "having light transmissiveness" at least means that the light transmittance of light having a wavelength of 400 nm or less from the other surface to the one surface is 50% or more.

Also, the "strength for functioning as the mold structure" means such strength that even when pressing and pressurization are performed with respect to the imprint resist layer 24 formed on the substrate 30 under a condition of an average surface pressure of 1 kgf/cm$^2$ or more, the substrate 30 is not releasably broken.

- Curing Step -

Subsequently, heat is applied to the imprint resist layer 24, or the imprint resist layer 24 is exposed with ultraviolet rays or the like to cure the transferred pattern. When exposure of ultraviolet rays is performed to cure the pattern, exposure of ultraviolet rays for curing may be performed after the patterning and after the mold structure and the master 11 (magnetic recording medium) are released from each other.

- Pattern Forming Step -

Subsequently, selective etching is performed by RIE or the like, using the transferred pattern as a mask to obtain the mold structure 1 having a concave-convex shape. Also, an inorganic material may be formed on the surface of the laminate, an inorganic material mask may be formed based on the resist mask, and the laminate may be etched using this inorganic material mask to form the mold structure 1.

[Release Layer Forming Step]

Subsequently, when the release layer 6 is formed as required, the release layer 6 of a material satisfying the formulas (1) and (2) is formed on the transfer surface of the mold structure 1, on which the concave-convex portion 3 is formed, to obtain the imprint mold structure 1.

(Magnetic Recording Medium)

A magnetic recording medium, such as discrete track media and patterned media, fabricated using the imprint mold structure according to the present invention will be described below with reference to the drawings. However, the magnetic recording medium according to the present invention may be fabricated by a manufacturing method other than the following manufacturing method as long as it is manufactured using the imprint mold structure according to the present invention.

As shown in FIG. 4, by pressing the mold structure 1 against the substrate 40 of the magnetic recording medium on which a magnetic layer 60, and the imprint resist layer 25 formed by applying the imprint resist solution are formed in this order, and performing pressurization, a pattern of the data region concave-convex portion 3 and the servo region concave-convex portion 3 formed on the mold structure 1 is transferred to the imprint resist layer 25.

Here, for the imprint resist layer 25 in the fabrication of the magnetic recording medium, the same imprint resist composition as that of the imprint resist layer 24 in the fabrication of the imprint mold structure may be used.

Hereinafter, the imprint resist layer and the imprint resist composition refer to the imprint resist layer 25 in the fabrication of the magnetic recording medium, and the imprint resist composition for forming the imprint resist layer 25 unless otherwise specified.

Subsequently, using as a mask the imprint resist layer 25 to which the pattern of the data region concave-convex portion 3 and the servo region concave-convex portion 3 is transferred, an etching step is performed to form a concave-convex pattern, based on the concave-convex portion formed on the mold structure 1, in the magnetic layer 50. The concave portions are filled with a nonmagnetic material to form a nonmagnetic layer 70. The surface is flattened, and then, other steps, such as the formation of a protective film, are performed, as required, to obtain the magnetic recording medium 100.

The etching step is the step of forming, in the magnetic layer 50 in the data region, a concave-convex shape based on the resist concave-convex pattern shape formed in the imprint resist layer 25 in the data region.

As the method for forming the convex-concave shape, an ion beam etching method, a reactive chemical etching method, a wet etching method, and the like can be used.

As the process gas in ion beam etching, Ar can be used. As the etchant in reactive chemical etching, CO + NHs, chlorine gas, and the like can be used.

The other steps include, as required, the step of filling the concave portions in the magnetic layer with a nonmagnetic material, such as $SiO_2$, carbon, and alumina; polymers, such as polymethyl methacrylate (PMMA) and polystyrene (PS); and a lubricating oil, the step of flattening the surface, the step of forming a protective film on the flattened surface with DLC (diamond-like carbon) or the like, the step of finally applying a lubricant, and the like.

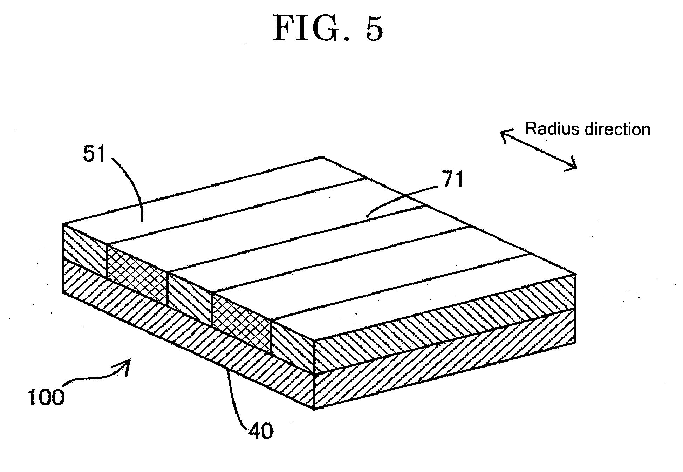

FIG. 5 is a perspective view showing the configuration of the magnetic recording medium of the present invention.

In the magnetic recording medium 100 of the present invention fabricated as described above, a plurality of data region magnetic pattern portions 51 concentrically formed on one surface of the substrate 40 at predetermined intervals are separated by the nonmagnetic layer 71, as shown in FIG. 5. The servo region magnetic pattern portions have a similar configuration.

Also, although not shown, on the surface of the substrate 40, in the region in which the data region magnetic pattern portions 51 are formed, a plurality of servo regions, in which the servo region magnetic pattern portions are formed on the surface, are formed at generally equal intervals in the circumferential direction so as to divide the data region.

Also in the magnetic recording medium of the present invention, the shape of the magnetic pattern portion 51 viewed in the direction of the normal to the surface of the substrate 40 (hereinafter sometimes referred to as the planar shape of the magnetic pattern portion 51) is generally rectangular.

EXAMPLES

The examples of the present invention will be described below, but the present invention is not limited to the following examples.

(Example 1)

<Fabrication of Imprint Mold Structure>

<<Fabrication of Master>>

An electron beam resist was applied onto an 8-inch diameter, disk-shaped Si substrate, with a thickness of 100 nm, using a spin coating method.

The desired pattern was exposed by a rotary electron beam exposure apparatus and developed to form the electron beam resist having a concave-convex pattern on the Si substrate.

Using as a mask the electron beam resist having the concave-convex pattern, reactive ion etching treatment was performed on the Si substrate to form a concave-convex shape on the Si substrate.

The remaining electron beam resist was removed by washing with a soluble solvent, and drying was performed to obtain a master.

Here, the concave-convex pattern is broadly divided into a concave-convex pattern in the data portion and a concave-convex pattern in the servo portion.

The data portion has a concave-convex pattern with the width of the convex portion being 120 nm, and the width of the concave portion being 30 nm (track pitch = 150 nm).

For the servo portion, the reference signal length is 90 nm, and the total number of sectors is 240. The servo portion is constituted by a preamble portion (45 bits), an SAM portion (10 bits), a sector code portion (8 bits), a cylinder code portion (32 bits), and a burst portion.

The SAM portion is "0000101011." The concave-convex pattern in the sector code portion is formed using binary conversion. The concave-convex pattern in the cylinder code portion is formed using gray conversion and is finally formed using Manchester conversion.

Also, the concave-convex pattern in the burst portion is a general phase burst signal (16 bits).

Subsequently, an acrylic resist (PAK-01-500, manufactured by Toyo Gosei Co., Ltd.) having 100 nm was formed on a quartz substrate by a spin coating method (3,600 rpm).

Then, nanoimprint was performed using the master. RIE using $CHF_3$ as an etchant was performed, based on the concave-convex resist pattern after the nanoimprint, to create the imprint mold structure. A release layer was formed on the surface on the transfer side of the fabricated imprint mold structure (the surface to be pressed against a resist) by a wet method. As the release agent constituting the release layer, EGC-1720 (manufactured by Sumitomo 3M Limited; fluorine-based surface treatment agent) was used.

<<Measurement of Hardness HMB of Substrate of Mold Structure>>

The hardness HMB of the quartz substrate was measured. The measurement of the hardness (surface hardness) was performed before the release layer was formed. The surface hardness is represented by microhardness. This is based on the experience that the hardness of the target outermost surface cannot be evaluated by a measurement method in which a large load is applied as in usual Vickers and Knoop hardness measurements. Specifically, as the measurement apparatus, TRIBOSCOPE (manufactured by HYSITRON) was used. This performed the measurement of the hardness HMB by a method in which a pickup electrode with an indenter mounted was placed between two electrode plates, and from a change in capacitance with the movement of the pickup electrode, the force and the displacement were detected with high sensitivity. The result is shown in Table 1.

<<Measurement of Hardness HMS of Outermost Surface (Release Layer) of Mold Structure>>

The hardness HMS of the outermost surface (release layer) of the mold was measured. The hardness was measured after the release layer was formed. The method for measuring the hardness HMS was performed as in the method for measuring the hardness HMB. The result is shown in Table 1.

<Fabrication of Magnetic Recording Medium>

Each layer was formed on a 2.5-inch glass substrate by the following procedure to fabricate a magnetic recording medium.

In the fabricated magnetic recording medium, a soft magnetic layer, a first nonmagnetic orientation layer, a second nonmagnetic orientation layer, a magnetic layer (sometimes referred to as a "magnetic recording layer"), a protective layer, and a lubricant layer were sequentially formed.

The soft magnetic layer, the first nonmagnetic orientation layer, the second nonmagnetic orientation layer, the magnetic recording layer, and the protective layer were formed by a sputtering method, and the lubricant layer was formed by a dipping method.

<Formation of Soft Magnetic Layer>

As the soft magnetic layer, a layer of CoZrNb was formed with a thickness of 100 nm.

Specifically, the glass substrate was placed opposed to a CoZrNb target, Ar gas was flowed in at a pressure of 0.6 Pa, and DC 1,500 W was used to form a film.

<Formation of First Nonmagnetic Orientation Layer>

As the first nonmagnetic orientation layer, a Ti layer having a thickness of 5 nm was formed.

Specifically, for the first nonmagnetic orientation layer, the glass substrate was placed opposed to a Ti target, Ar gas was flowed in at a pressure of 0.5 Pa, and discharge was performed at DC 1,000 W to form a Ti seed layer with a thickness of 5 nm.

<Formation of Second Nonmagnetic Orientation Layer>

Subsequently, as the second nonmagnetic orientation layer, a Ru layer having a thickness of 10 nm was formed.

After the first nonmagnetic orientation layer was formed, the glass substrate was placed opposed to a Ru target, Ar gas was flowed in at a pressure of 0.5 Pa, and discharge was performed at DC 1,000 W to form a Ru layer as the second nonmagnetic orientation layer with a thickness of 10 nm.

<Formation of Magnetic Recording Layer>

Subsequently, as the magnetic recording layer, a CoCrPtO layer was formed with a thickness of 15 nm.
Specifically, the glass substrate was placed opposed to a CoPtCr target, Ar gas containing 0.04% $O_2$ was flowed in at a pressure of 18 Pa, and discharge was performed at DC 290 W to form a magnetic recording layer.

<Formation of Protective Layer>

After the magnetic layer was formed, the glass substrate was placed opposed to a C target, Ar gas was flowed in at a pressure of 0.5 Pa, and discharge was performed at DC 1,000 W to form a C protective layer with a thickness of 4 nm.
The coercivity of the magnetic recording medium was 334 kA/m (4.2 kOe).
Also, the first nonmagnetic material of the magnetic recording medium in this example was PtO.

<Formation of Imprint Resist Layer>

The acrylic resist (manufactured by Toyo Gosei Co., Ltd., PAK-01-500) was applied onto the protective layer with a thickness of 100 nm by the spin coating method (3,600 rpm) to form an imprint resist layer.

<<Measurement of Hardness HBR of Resist>>

The hardness HBR of the resist before a curing step was performed was measured. Specifically, a resist layer (PAK-01-500, manufactured by Toyo Gosei Co., Ltd.) with a thickness of 100 nm was formed on a quartz substrate by the spin coating method (3,600 rpm). The hardness HBR of the resist was measured using the measurement apparatus TRIBOSCOPE (manufactured by HYSITRON). Indentation was performed at an indentation load of 5 $\mu$N, at an indentation speed of 3 nm/second, using the triangular pyramid type having a diamond tip having a dihedral angle of 90 degrees and a curvature radius of 40 nm. A pressure of up to 5 $\mu$N was applied, and subsequently, the pressure was gradually returned. The maximum load at this time, 5 $\mu$N, was divided by the projected area of the indenter contact portion to obtain the hardness. The result is shown in Table 1.

<Transferring Step and Curing Step>

The surface of the above mold on which the concave-convex portion was formed was located opposed to the substrate on which the imprint resist layer was formed, and the substrate on which the imprint resist layer was formed was brought into close contact with the mold at a pressure of 3 MPa for 10 seconds and exposed with ultraviolet rays at 10 mJ/cm$^2$.
After the above steps were finished, the mold was released from the substrate on which the imprint resist layer was formed.
Subsequently, the imprint resist layer remaining in the concave portions of the concave-convex pattern, which was formed in the imprint resist layer by transferring the concave-convex pattern based on the concave-convex portion of the mold to the imprint resist layer, was removed by $O_2$ reactive chemical etching. This $O_2$ reactive chemical etching was performed so that the magnetic layer was exposed in the concave portions.

<<Measurement of Hardness HAR of Resist>>

The hardness HAR of the resist, to which the pattern was transferred by pressing the mold and which was cured by being exposed with ultraviolet rays, was measured.
The above quartz substrate to which the resist was applied was exposed with ultraviolet rays to sufficiently cure the resist. The conditions of the ultraviolet ray irradiation were 10 mJ/cm$^2$ and 30 seconds. Subsequently, the hardness HAR of the resist was measured. Specifically, measurement was performed using the measurement apparatus TRIBOSCOPE (manufactured by HYSITRON). Indentation was performed at an indentation load of 5 $\mu$N, at an indentation speed of 3 nm/second, using the triangular pyramid type having a diamond tip having a dihedral angle of 90 degrees and a curvature radius of 40 nm. A pressure of up to 5 $\mu$N was applied, and subsequently, the pressure was gradually returned. The maximum load at this time, 5 $\mu$N, was divided by the projected area of the indenter contact portion to obtain the hardness HAR. The result is shown in Table 1.

<Magnetic Pattern Portion Forming Step>

After the imprint resist layer remaining in the concave portions was removed, the magnetic layer was processed into a concave-convex shape.

For the processing of the magnetic layer, an ion beam etching method was used.

Specifically, Ar gas was used, the ion acceleration energy was 500 eV, and the ion beam was applied to the magnetic layer in the vertical direction.

After the magnetic layer was thus processed, the resist remaining on the magnetic layer (unprocessed portions) was removed by $O_2$ reactive chemical etching.

Subsequently, a PFPE lubricant was applied with a thickness of 2 nm by a dipping method.

<Nonmagnetic Pattern Portion Forming Step>

After the above magnetic layer was processed, sputtering was performed to form a $SiO_2$ layer with a thickness of 50 nm as a layer including the magnetic material, and the $SiO_2$ layer was removed by ion beam etching so that the magnetic layer was flush with the nonmagnetic layer.

<<Evaluation of Moldability of Resist Pattern>>

Using the intermediate of the magnetic recording medium before the magnetic layer was formed, the shape of the resist was compared between the data region and the servo region, and the evaluation of the moldability of the resist pattern was performed as follows.

First, the intermediate of a perpendicular magnetic recording medium on which the resist pattern was formed through the transferring step was ruptured, and the film thickness "A" of the remaining resist of the resist pattern in the data region, and the film thickness "B" of the remaining resist of the resist pattern in the burst portion in the servo region, with respect to a cross section after the rupture, were measured using a scanning electron microscope (FE-SEM S800, manufactured by Hitachi, Ltd.). The measurement was performed at eight points at substantially equal angular intervals at a radius of 25 mm for a magnetic recording medium, an average of these measurements was calculated, and a ratio of the film thicknesses (B/A) was evaluated according to the criteria shown below. The result is shown in Table 1.

[Evaluation Criteria]

    A: the value of the ratio B/A was in the range of 0.8 to 1.0

    B: the value of the ratio B/A was less than 0.8

<Evaluation of Magnetic Recording Medium>

<<Evaluation of Quality of Servo Signal>>

For the evaluation of servo address errors, BitFinder manufactured by IMES Co., Ltd. was used as an evaluation apparatus. In the apparatus, a GMR head with a read width of 120 nm and a write width of 200 nm was mounted for a VCM mode, and the evaluation of servo following was performed. Specifically, the address error rate in the state of servo following was calculated. The number of address errors occurring for 50 rotations was detected, and the address error rate with respect to the number of all sectors evaluated was obtained. The evaluation was made according to the criteria shown below. The result is shown in Table 1.

[Evaluation Criteria]

    Good: the address error rate was less than 0.1%

    N.G.: the address error rate was 0.1% or more

(Example 2)

<Fabrication of Imprint Mold Structure>

An imprint mold structure was fabricated as in Example 1, except that the material of the release layer formed on the surface on the transfer side of the mold structure in Example 1 was changed to Z-DOL (manufactured by Solvay Solexis; fluorocarbon-based material), and the hardnesses HMS and HMB were measured. The result is shown in Table 1.

<Fabrication of Magnetic Recording Medium>

Using the imprint mold structure fabricated above, the magnetic recording medium of Example 2 was fabricated as in Example 1, and the hardnesses HBR and HAR were measured. The result is shown in Table 1.

<<Evaluation of Moldability of Resist Pattern>>

The moldability of the resist pattern was evaluated as in Example 1. The result is shown in Table 1.

<Evaluation of Magnetic Recording Medium>

The quality of the servo signal was evaluated as in Example 1. The result is shown in Table 1.

(Example 3)

<Fabrication of Imprint Mold Structure>

An imprint mold structure was fabricated as in Example 1, and the hardnesses HMS and HMB were measured. The result is shown in Table 1.

<Fabrication of Magnetic Recording Medium>

The magnetic recording medium of Example 3 was fabricated as in Example 1, except that a novolak-based resist (mr-I7000E, manufactured by micro resist technology GmbH) was used in place of the acrylic resist (PAK-01-500, manufactured by Toyo Gosei Co., Ltd.), and the hardnesses HBR and HAR were measured. The result is shown in Table 1.

<<Evaluation of Moldability of Resist Pattern>>

The moldability of the resist pattern was evaluated as in Example 1. The result is shown in Table 1.

<Evaluation of Magnetic Recording Medium>

The quality of the servo signal was evaluated as in Example 1. The result is shown in Table 1.

(Example 4)

<Fabrication of Imprint Mold Structure>

An imprint mold structure was fabricated as in Example 1, except that the substrate in Example 1 was changed from quartz to Ni and that a plating method was used for the fabrication of a Ni mold, and the hardnesses HMS and HMB were measured. The result is shown in Table 1.

<Fabrication of Magnetic Recording Medium>

Using the imprint mold structure fabricated above, the magnetic recording medium of Example 4 was fabricated as in Example 1, and the hardnesses HBR and HAR were measured. The result is shown in Table 1.

<<Evaluation of Moldability of Resist Pattern>>

The moldability of the resist pattern was evaluated as in Example 1. The result is shown in Table 1.

<Evaluation of Magnetic Recording Medium>

The quality of the servo signal was evaluated as in Example 1. The result is shown in Table 1.

(Example 5)

<Fabrication of Imprint Mold Structure>

An imprint mold structure was fabricated as in Example 1, except that the substrate in Example 1 was changed from quartz to Al and that NIL (nanoimprint lithography) and RIE (reactive ion etching) were used for the fabrication of an Al mold, and the hardnesses HMS and HMB were measured. The result is shown in Table 1.

<Fabrication of Magnetic Recording Medium>

Using the imprint mold structure fabricated above, the magnetic recording medium of Example 5 was fabricated as in Example 1, and the hardnesses HBR and HAR were measured. The result is shown in Table 1.

<<Evaluation of Moldability of Resist Pattern>>

The moldability of the resist pattern was evaluated as in Example 1. The result is shown in Table 1.

<Evaluation of Magnetic Recording Medium>

The quality of the servo signal was evaluated as in Example 1. The result is shown in Table 1.

(Example 6)

<Fabrication of Imprint Mold Structure>

An imprint mold structure was fabricated as in Example 1, except that the material of the release layer formed on the surface on the transfer side of the mold structure in Example 1 was changed to Z-TETRAOL (manufactured by Solvay Solexis; fluorocarbon-based material), and the hardnesses HMS and HMB were measured. The result is shown in Table 1.

<Fabrication of Magnetic Recording Medium>

Using the imprint mold structure fabricated above, the magnetic recording medium of Example 6 was fabricated as in Example 1, and the hardnesses HBR and HAR were measured. The result is shown in Table 1.

<<Evaluation of Moldability of Resist Pattern>>

The moldability of the resist pattern was evaluated as in Example 1. The result is shown in Table 1.

<Evaluation of Magnetic Recording Medium>

The quality of the servo signal was evaluated as in Example 1. The result is shown in Table 1.

(Comparative Example 1)

<Fabrication of Imprint Mold Structure>

An imprint mold structure was fabricated as in Example 1, except that instead of the formation of the release layer in Example 1, a 50-nm DLC (diamond-like carbon) layer was formed by an ion gun, and the hardnesses HMS and HMB were measured. The result is shown in Table 1.

<Fabrication of Magnetic Recording Medium>

Using the imprint mold structure fabricated above, the magnetic recording medium of Comparative Example 1 was fabricated as in Example 1, and the hardnesses HBR and HAR were measured. The result is shown in Table 1.

<<Evaluation of Moldability of Resist Pattern>>

The moldability of the resist pattern was evaluated as in Example 1. The result is shown in Table 1.

<Evaluation of Magnetic Recording Medium>

The quality of the servo signal was evaluated as in Example 1. The result is shown in Table 1.

(Comparative Example 2)

<Fabrication of Imprint Mold Structure>

An imprint mold structure was fabricated as in Example 1, except that instead of the formation of the release layer in Example 1, a C (carbon) layer was formed by sputtering, and the hardnesses HMS and HMB were measured. The result is shown in Table 1.
For the C (carbon) layer, after etching by RIE, the concave-convex surface of the mold was placed opposed to a C target, Ar gas was flowed in at a pressure of 0.3 Pa, and discharge was performed at DC 700 W to form the C (carbon) layer with a thickness of 100 nm.

<Fabrication of Magnetic Recording Medium>

Using the imprint mold structure fabricated above, the magnetic recording medium of Comparative Example 2 was fabricated as in Example 1, and the hardnesses HBR and HAR were measured. The result is shown in Table 1.

<<Evaluation of Moldability of Resist Pattern>>

The moldability of the resist pattern was evaluated as in Example 1. The result is shown in Table 1.

<Evaluation of Magnetic Recording Medium>

The quality of the servo signal was evaluated as in Example 1. The result is shown in Table 1.

(Comparative Example 3)

<Fabrication of Imprint Mold Structure>

An imprint mold structure was fabricated as in Example 1, except that the release layer in Example 1 was not formed, and the hardnesses HMS and HMB were measured. The result is shown in Table 1.

<Fabrication of Magnetic Recording Medium>

Using the imprint mold structure fabricated above, the magnetic recording medium of Comparative Example 3 was fabricated as in Example 1, and the hardnesses HBR and HAR were measured. The result is shown in Table 1.

<<Evaluation of Moldability of Resist Pattern>>

The moldability of the resist pattern was evaluated as in Example 1. The result is shown in Table 1.

<Evaluation of Magnetic Recording Medium>

The quality of the servo signal was evaluated as in Example 1. The result is shown in Table 1.

(Comparative Example 4)

<Fabrication of Imprint Mold Structure>

An imprint mold structure was fabricated as in Example 1, except that the substrate in Example 1 was changed from quartz to Ni and that the release layer in Example 1 was not formed, and the hardnesses HMS and HMB were measured. The result is shown in Table 1.

<Fabrication of Magnetic Recording Medium>

Using the imprint mold structure fabricated above, the magnetic recording medium of Comparative Example 4 was fabricated as in Example 1, and the hardnesses HBR and HAR were measured. The result is shown in Table 1.

<<Evaluation of Moldability of Resist Pattern>>

The moldability of the resist pattern was evaluated as in Example 1. The result is shown in Table 1.

<Evaluation of Magnetic Recording Medium>

The quality of the servo signal was evaluated as in Example 1. The result is shown in Table 1.

(Comparative Example 5)

<Fabrication of Imprint Mold Structure>

An imprint mold structure was fabricated as in Example 1, and the hardnesses HMS and HMB were measured. The result is shown in Table 1.

<Fabrication of Magnetic Recording Medium>

Using the imprint mold structure fabricated above, the magnetic recording medium of Comparative Example 5 was fabricated as in Example 1, except that Teflon (registered trademark) was used in place of the acrylic resist (PAK-01-500, manufactured by Toyo Gosei Co., Ltd.), and the hardnesses HBR and HAR were measured. The result is shown in Table 1.

<<Evaluation of Moldability of Resist Pattern>>

The moldability of the resist pattern was evaluated as in Example 1. The result is shown in Table 1.

<Evaluation of Magnetic Recording Medium>

The quality of the servo signal was evaluated as in Example 1. The result is shown in Table 1.

Table 1

| | HBR (GPa) | HMS (GPa) | HAR (GPa) | HMB (GPa) | Resist pattern moldability | | Servo signal quality | |
| --- | --- | --- | --- | --- | --- | --- | --- | --- |
| | | | | | Measured value (average) | Determination | Adress error rate (%) | Determination |
| Ex. 1 | 0.01 | 0.2 | 0.5 | 10.00 | 0.95 | A | 0.001 | A |
| Ex. 2 | 0.01 | 0.1 | 0.5 | 10.00 | 0.98 | A | 0.03 | A |
| Ex. 3 | 0.08 | 0.2 | 0.3 | 10.00 | 0.93 | A | 0.02 | A |
| Ex. 4 | 0.01 | 0.2 | 0.5 | 5.00 | 0.99 | A | 0.005 | A |
| Ex. 5 | 0.01 | 0.2 | 0.5 | 3.00 | 0.93 | A | 0.003 | A |
| Ex. 6 | 0.01 | 0.15 | 0.5 | 10.00 | 1.00 | A | 0.0005 | A |

(continued)

| | HBR (GPa) | HMS (GPa) | HAR (GPa) | HMB (GPa) | Resist pattern moldability | | Servo signal quality | |
|---|---|---|---|---|---|---|---|---|
| | | | | | Measured value (average) | Determination | Adress error rate (%) | Determination |
| Com. Ex. 1 | 0.01 | 20 | 0.5 | 10.00 | 0.96 | A | 0.21 | B |
| Com. Ex. 2 | 0.01 | 10 | 0.5 | 10.00 | 0.93 | A | 0.18 | B |
| Com. Ex. E | 0.01 | 10 | 0.5 | 10.00 | 0.93 | A | 0.19 | B |
| Com. Ex. 4 | 0.01 | 5 | 0.5 | 5.00 | 0.94 | A | 0.15 | B |
| Com. Ex. 5 | 0.2 | 0.2 | 0.3 | 10.00 | 0.79 | B | 0.08 | A |

As shown in Table 1, Examples 1 to 6 satisfying formula (1) provided imprint mold structures having higher releasability than that of Comparative Examples 1 to 5 not satisfying formula (1).

Also, the use of the imprint mold structures fabricated in Examples 1 to 6 satisfying formula (1) provided magnetic recording media having signal quality properties superior to those of Comparative Examples 1 to 5 not satisfying formula (1).

**Claims**

1.  An imprint mold structure comprising:

   a substrate; and
   a concave-convex portion formed by arranging on one surface of the substrate a plurality of convex portions with reference to the surface,
   the imprint mold structure being used for an imprint method comprising at least:

   pressing the concave-convex portion of the imprint mold structure as a transfer surface against an imprint resist layer formed of an imprint resist composition on a laminate comprising a substrate for a magnetic recording medium and at least a magnetic layer laminated on the substrate so as to transfer a concave-convex pattern based on the concave-convex portion; and
   curing the imprint resist layer to which the concave-convex pattern is transferred,

   wherein the imprint mold structure satisfies the following formula 1:

$$HBR < HMS < HAR \qquad\qquad \text{Formula 1}$$

   in which HMS is a hardness of an outermost surface on the transfer side of the imprint mold structure, HBR is a hardness of the imprint resist layer in the transferring, HAR is a hardness of the imprint resist layer after the curing, and HMS is 1 GPa or less.

2.  The imprint mold structure according to claim 1, wherein the imprint mold structure further comprises at least one release layer on the surface on the transfer side of the imprint mold structure.

3.  The imprint mold structure according to any of claim 1 or 2, wherein the outermost surface on the transfer side of the imprint mold structure is a release layer.

4.  The imprint mold structure according to any of claim 2 or 3, wherein a material of the release layer is a fluorocarbon-based material.

5.  The imprint mold structure according to anyone of claims 1 to 4,
   wherein the imprint mold structure satisfies the following formula 2:

$$HMS < HMB \qquad\qquad Formula\ 2$$

in which HMB is a hardness of the substrate of the imprint mold structure, and HMB is 5 GPa or more.

6. An imprint method comprising:

pressing a concave-convex portion of the imprint mold structure as a transfer surface against an imprint resist layer formed of an imprint resist composition on a laminate comprising a substrate for a magnetic recording medium and at least a magnetic layer laminated on the substrate so as to transfer a concave-convex pattern based on the concave-convex portion; and
curing the imprint resist layer to which the concave-convex pattern is transferred,

wherein the imprint mold structure comprises:

a substrate; and
the concave-convex portion formed by arranging on one surface of the substrate a plurality of convex portions with reference to the surface, and

wherein the imprint mold structure satisfies the following formula 1:

$$HBR < HMS < HAR \qquad\qquad Formula\ 1$$

in which HMS is a hardness of an outermost surface on the transfer side of the imprint mold structure, HBR is a hardness of the imprint resist layer in the transferring, HAR is a hardness of the imprint resist layer after the curing, and HMS is 1 GPa or less.

7. The imprint method according to claim 6, wherein the imprint mold structure further comprises a release layer on the outermost surface on the transfer side of the imprint mold structure, and wherein the imprint mold structure satisfies the following formula 2:

$$HMS < HMB \qquad\qquad Formula\ 2$$

in which HMS is a hardness of the release layer, HMB is a hardness of the substrate of the imprint mold structure, and HMB is 5 GPa or more.

8. The imprint method according to claim 7, wherein a material of the release layer is a fluorocarbon-based material.

9. A method for manufacturing a magnetic recording medium, comprising:

pressing an imprint mold structure against an imprint resist layer formed of an imprint resist composition on a laminate comprising a substrate for a magnetic recording medium and at least a magnetic layer laminated on the substrate so as to transfer a concave-convex pattern based on a concave-convex portion of the imprint mold structure, the imprint mold structure comprising a substrate, and the concave-convex portion formed by arranging on one surface of the substrate a plurality of convex portions with reference to the surface;
curing the imprint resist layer to which the concave-convex pattern is transferred;
etching the magnetic layer, using as a mask the imprint resist layer, to which the concave-convex pattern is transferred and which is cured, to form a magnetic pattern portion, based on the concave-convex pattern, in the magnetic layer; and
filling a concave portion dividing the magnetic layer with a nonmagnetic material to form a nonmagnetic pattern portion,

wherein the imprint mold structure satisfies the following formula 1:

$$HBR < HMS < HAR \qquad \text{Formula 1}$$

in which HMS is a hardness of a transfer surface of the imprint mold structure, HBR is a hardness of the imprint resist layer in the transferring, HAR is a hardness of the imprint resist layer after the curing, and HMS is 1 GPa or less.

**10.** The method for manufacturing a magnetic recording medium according to claim 9, wherein the imprint mold structure further comprises a release layer on the outermost surface on the transfer side of the imprint mold structure, and wherein the imprint mold structure satisfies the following formula 2:

$$HMS < HMB \qquad \text{Formula 2}$$

in which HMS is a hardness of the release layer, HMB is a hardness of the substrate of the imprint mold structure, and HMB is 5 GPa or more.

**11.** The method for manufacturing a magnetic recording medium according to claim 10, wherein a material of the release layer is a fluorocarbon-based material.

# FIG. 1

# FIG. 2

# FIG. 3A

21

10

11

# FIG. 3B

# FIG. 4

# FIG. 5

Radius direction

51

71

100

40

**EUROPEAN SEARCH REPORT**

Europäisches Patentamt
European Patent Office
Office européen des brevets

Application Number

EP 09 00 4171

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| P,X | EP 2 037 453 A (FUJI) 18 March 2009 (2009-03-18) * page 10, line 8 - line 40 * * page 10, line 56 - page 11, line 46 * * page 12, line 13 - line 31; figures 3,4 * | 1-11 | INV. G11B5/855 B29C33/38 B29C33/42 |
| A | US 6 949 199 B1 (GAUZNER ET AL.) 27 September 2005 (2005-09-27) * column 1, line 14 - line 20 * * column 2, line 46 - line 65; figures 1-3 * | 1-11 | |
| A | US 6 869 557 B1 (WAGO ET AL.) 22 March 2005 (2005-03-22) * column 1, line 13 - line 19 * * column 2, line 47 - line 66; figures 1,2 * | 1-11 | |
| A | EP 1 696 471 A (TOKYO UNIVERSITY OF AGRICULTURE AND TECHNOLOGY) 30 August 2006 (2006-08-30) * page 4, line 4 - line 5; figures 2,3 * | 1-11 | TECHNICAL FIELDS SEARCHED (IPC) G11B B29C G03F H01L B81C |

The present search report has been drawn up for all claims

| Place of search | Date of completion of the search | Examiner |
|---|---|---|
| The Hague | 28 May 2009 | Magrizo, Simeon |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 09 00 4171

This annex lists the patent family members relating to the patent documents cited in the above-mentioned European search report.
The members are as contained in the European Patent Office EDP file on
The European Patent Office is in no way liable for these particulars which are merely given for the purpose of information.

28-05-2009

| Patent document cited in search report | | Publication date | Patent family member(s) | | Publication date |
|---|---|---|---|---|---|
| EP 2037453 | A | 18-03-2009 | JP<br>US | 2009070483 A<br>2009075122 A1 | 02-04-2009<br>19-03-2009 |
| US 6949199 | B1 | 27-09-2005 | NONE | | |
| US 6869557 | B1 | 22-03-2005 | NONE | | |
| EP 1696471 | A | 30-08-2006 | WO<br>KR<br>US | 2005057634 A1<br>20060128886 A<br>2007117389 A1 | 23-06-2005<br>14-12-2006<br>24-05-2007 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004221465 A

- JP 2002203342 A